# EUROPEAN PATENT APPLICATION

(11) **EP 2 492 273 A1**
(43) Date of publication of application: **29.08.2012**
(21) Application number: 11305190.8
(22) Date of filing: 23.02.2011
(51) Int. Cl.: C07F 5/00, C23C 14/00

(54) **Deposition of gallium containing thin films using gallium alkylamide precursor**

(71) Applicant: L'Air Liquide Société Anonyme pour l'Etude et l'Exploitation des Procédés Georges Claude, 75007 Paris (FR)
(72) Inventor: LACHAUD, Christophe, 91240 SAINT-MICHEL SUR ORGE (FR); ZAUNER, Andreas, 78960 VOISINS LE BRETONNEUX (FR)
(74) Representative: Grout de Beaufort, François-Xavier

(57) **Abstract**

Compounds of formula (I): [(Rₐ)(R_{b})Ga(NR_{c}R_{d})]₂, wherein:
- Ra and Rb are independently selected in the group consisting of H, C1-C6 linear or branched alkyl, aryl or alkylsilyl;
- Rc and Rd are independently selected in the group consisting of C1-C4 linear or branched alkyl, aryl or alkylsilyl.

## Description

Gallium is a rare metal which is most commonly recovered from the zinc-sulfide mineral sphalerite. Despite its rarity, gallium is used in multitude of technical applications from electronic to photovoltaic and optical devices. Gallium is dominantly used in gallium tin oxide layers (GaTO) for flat panel displays, copper- gallium -selenide (CGaS) type of solar cells, indium-gallium-nitride (InGaN) as used for LEDs; blue-ray lasers and InGaP for optoelectronic devices. In contrast to GaTO and CGaS that are mainly deposited by PVD, InGaN is mainly deposited by metal-organic chemical vapor deposition (MOCVD).

In addition to above utilizations, gallium can also be used for other applications. The usage of Ga₂S₃ to replace CdS in a photovoltaic CGaS based stack: CGaS/CdS/ZnO/ZnO:Al to obtain a better cell efficiency is already known. Gallium is also reported to be used in phase-change materials (PCM) such as Ge₂Sb₂Te₅ (GST), to form gallium containing GST alloys to improve PCM characteristics such as data retention. Gallium can also be used in other PCM as Ga-Ge-Te (GaGT), Ga-Sb-Te (GaST), or AgGaSbTe. Alternatively, Ga₂Se₃ might be used for PCM fabrication. It is known that Ga₂Se₃ has a wider variation in electrical resistivity in comparison with the previous Ge₂Sb₂Te₅ and therefore could be an alternative to GST.

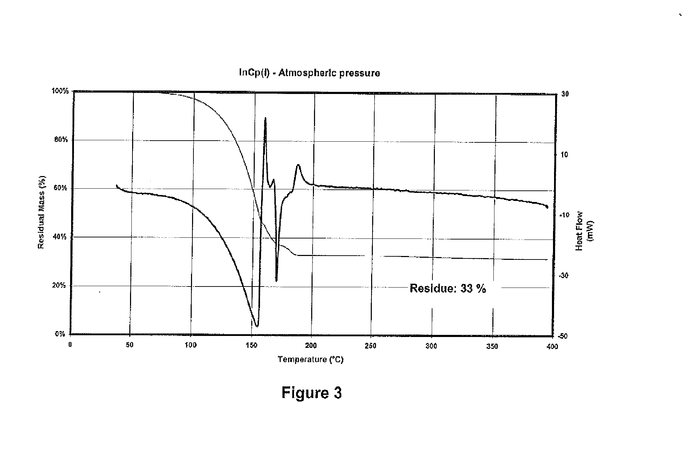

MOCVD and ALD are common techniques to deposit thin films that can also be used for GST depositions. These techniques require ideally stable and volatile precursors. Concerning metal precursors several sources of metal are described in literature:
- The deposition of InGaN by MOCVD from trimethylindium (TMI) is disclosed. Deposition from TMI of GaInP is already known. TMI is very volatile and reactive but is a pyrophoric compound. This last characteristic complicates its handling which requires special safety procedures.
- InCl₃ and InCl are probably the most simple indium precursors but their lack of volatility (sublimation of InCl₃: 133 Pa at 356°C) is a significant disadvantage. Another drawback is the generation of chlorine during deposition. Cl₂ will damage the deposited layer.
- InCp is another commercial indium source. This molecule is volatile but its main disadvantage is its heat sensitivity (results shown on figure 3). Heating is necessary for vaporizing the compound and therefore decomposition will occur and a clogging of the distribution line is expected.
- In(N₃)₃Py₃ was characterized by TGA in the literature, to check the feasibility of using for InN deposition by MOCVD. It appears that the precursor decomposes firstly at 120°C and detonates at 300°C. In a safety point of view, this behavior is not acceptable for an industrial usage.
- For InS deposition, the use of Indium acetylacetonate is known, but thermal analysis of this precursor shows a high level of residues after complete vaporization. This phenomenon will generate particles and clogging in the distribution lines.

In conclusion, there are no suitable non-pyrophoric gallium metal-organic compounds with the desired thermal behaviour to enable the vapor phase deposition of gallium containing thin films.

According to a first embodiment, the invention relates to compounds of formula (I): [(Rₐ)(R_{b})Ga(NR_{c}R_{d})]₂, wherein:
- Ra and Rb are independently selected in the group consisting of H, C1-C6 linear or branched alkyl, aryl or alkylsilyl;
- Rc and Rd are independently selected in the group consisting of C1-C4 linear or branched alkyl, aryl or alkylsilyl.

According to another embodiment, the invention concerns compounds as defined above wherein Ra and Rb are a methyl group.

According to another embodiment, the invention concerns compounds as defined above wherein Rc and Rd which may be identical or different are independently chosen between methyl and ethyl.

According to another embodiment, the invention concerns the compounds:
[Me₂Ga(NEtMe)]₂, [Me₂Ga(NEt₂)]₂.

According to another embodiment, the invention concerns a method for forming a gallium containing thin film on a substrate comprising at least the steps of:
a) providing a vapor comprising at least one precursor compound of the formula (I) as defined above;
b) reacting the vapor comprising the at least one compound of formula (I) with the substrate, according to an atomic layer deposition process, to form a layer of an gallium-containing complex on at least one surface of said substrate.

According to another embodiment, the invention concerns a method as defined above further comprising the step:
c) reaction of the complex formed obtained in step b) with a reagent selected from another metal source, reducing reactants and/or nitriding reactants and/or oxidizing reactants.

According to another embodiment, the invention concerns a method of manufacturing a semiconductor structure, comprising the steps of the method defined above, wherein the substrate is a semiconductor substrate.

According to another embodiment, the invention concerns a method of manufacturing a photovoltaic structure, comprising the steps of the method defined above, wherein the substrate is a photovoltaic substrate.

According to another embodiment, the invention concerns the use of at least one compound as defined above for the manufacturing of phase change materials (PCM).

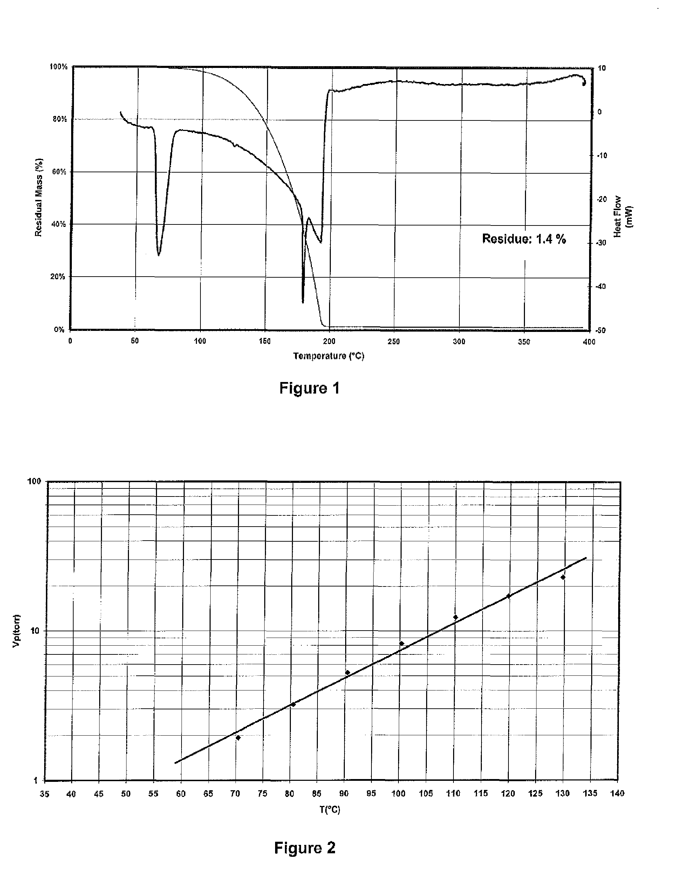

The new gallium metal-organic compounds present at least the following features:
1) controlling the steric bulk of Rc and Rd will enable to form monomeric compounds;
2) being liquid or being easily sublimized or having a melting point below 180°C;
3) being thermally stable (see figure 1);
4) having sufficient volatility for vapor phase distribution (see figure 2);
5) enabling the deposition by ALD of gallium containing thin films such as Gadoped GST, Ga₂Se₃, InGaN,...;
6) avoiding the pyrophoricity.

The present invention introduces the using of a low melting point, volatile and thermally stable gallium compounds to deposit gallium containing thin films by either ALD process.

According to another embodiment of the invention, the family of gallium precursor of the present invention can be used for the deposition of gallium containing thin films by (MO)CVD (Metal-Organic Chemical Vapor Deposition) and derivatives.

Surprisingly, this novel family of metal-organic compounds presents particularly attractive thermal properties. As a matter of fact, the new precursors present the advantages of:
1) being liquid at room temperature or having a melting point lower than 180°C;
2) being thermally stable enough to enable proper distribution (gas phase or direct liquid injection) without particles generation;
3) being thermally stable enough to allow wide self-limited ALD window (see figure 1);
4) allowing to deposit a variety of gallium containing thin films, including binary, ternary or quaternary materials. Gallium can also be used as dopant. To obtain a thin film with the expected composition and physical properties, the precursor can be used in combination with a co-reactant or combination of co-reactants. The co-reactants are selected without limitation among the group consisting of O₂, Plasma O₂, H₂O, O₃, N₂, NH₃, hydrazine and alkyl derivatives, N-containing radicals (for instance N., NH., NH₂.), NO, N₂O, NO₂, amines, GeCl₂, SbCl₃, TeCl₄,TDMAGe, TDMASb, DIPT...;
5) having sufficient volatility for vapor phase distribution (see figure 2);
6) enabling the deposition by ALD of gallium containing thin films such as Gadoped GST, Ga₂Se₃, InGaN,...

Those skilled in the art will recognize that the novel metal-organic compounds could be used in various applications fields such as electronic, photovoltaic, optoelectronic devices.

### Method of depositing gallium containing thin films:

The deposition of an gallium containing film is performed in several steps:
   a. Vaporizing an gallium source to form a gas-phase gallium source.
   b. Introducing several precursors in vapor phase in a deposition device, wherein said precursors comprise said vaporized gallium source, and may comprise another metal source, an oxygen source, a nitrogen source, a germanium source, an antimony source, a tellurium source or a selenium source to form an gallium containing film.
      1. In one embodiment of the invention, the precursor is stored in a heated canister. The vaporization of the precursor can be realized by introducing a gas in the said canister. The canister is preferably heated at a temperature which allows liquefying or subliming the said precursor with a sufficient vapor pressure. The carrier gas can be selected, from Ar, He, H₂, N₂ or mixtures of them. The carrier gas flow is in the range of 1 mL/min to 1 L/min. The canister can for instance be heated at temperatures in the range of 20°C to 180°C. The temperature can be adjusted to control the amount of precursor in the gas phase.
      2. In one embodiment of the invention, the precursor is stored in a heated canister. The vaporization of the precursor can be realized by drawing the vapour to the reactor chamber without using a carrier gas flow.
      3. In another embodiment of the invention, the said precursor source is fed in the liquid state to a vaporizer where it is vaporized.
      4. In another embodiment, the said precursor can be mixed with a stabilizer.
      5. The said precursor source can be mixed to a solvent or a mixture of solvent. The said solvent can be selected from the group consisting of octane, hexane, pentane, tetramethylsilane, mesithylene, and other aromatic solvents. This mixture is contained in a canister which can be heated at a temperature in the range of 20°C to 180°C.
      6. In another embodiment of the invention, the said precursor source can be mixed to a solvent or a mixture of solvents and one or more other metal source. The said solvent can be selected from the group consisting of octane, hexane, pentane, tetramethylsilane, mesithylene and other aromatic solvents. This mixture is contained in a canister which can be heated at a temperature in the range of 20°C to 180°C.
      7. In another embodiment of the invention, the said mixtures are fed in the liquid state to a vaporizer where they are vaporized.
      8. In another embodiment of the invention, the said mixtures can be mixed with a stabilizer.
      9. In one embodiment of the invention, the pressure in the said canister is in the range from 0.1 Pa to 101300 Pa (related to 1 to 4).
      10. In one embodiment of the invention, the pressure in the said canister is in the range from 100000 Pa to 400000 Pa (related to 5 to 7).
      11.The said vaporized metal source is introduced into a reaction chamber where it is contacted to a substrate. The substrate can be selected from the group consisting of Si, Si0₂, SiN, SiON, and other metal containing films. The substrate can be heated to sufficient temperature to obtain the desired film at sufficient growth rate and with desired physical state and composition. Typical temperature range from 50°C to 600°C. Preferably the temperature is lower or equal to 450°C. The pressure in the reaction chamber is controlled to obtain the desired metal containing film at sufficient growth rate. Typical pressure range from 0.1 Pa to 13300 Pa or higher. The metal source gas flow is in the range of 1 mL/min to 1 L/min.
      12. In one embodiment of the invention, the said new precursor source or the mixture described in 4, 5, 6, and 8 is mixed to one or more reactant species prior to the reaction chamber.
      13. In one embodiment of the invention, the said new precursor source or the mixture described in 4, 5, 6, and 8 is mixed to one or more reactant species in the reaction chamber.
      14.In another embodiment of the invention, the said new precursor and the reactant species can be introduced simultaneously (chemical vapor deposition), sequentially (atomic layer deposition) or different combinations. One example is to introduce metal source and the other metal source together in one pulse and co-reactant in a separate pulse (modified atomic layer deposition); another example is to introduce the reactant species (one example could be oxygen) continuously and to introduce metal source by pulse (pulsed-chemical vapor deposition). Typical temperature range from 50°C to 600°C. Preferably the temperature is lower or equal to 450°C. The pressure in the reaction chamber is controlled to obtain the desired metal containing film at sufficient growth rate. Typical pressure range from 10.1 Pa to 13300 Pa or higher. For each reactant, the gas flow is in the range of 1mL/min to 1 L/min.
      15. In one embodiment of the invention, the reactant species are passed through a plasma system localized remotely from the reaction chamber, and decomposed to radicals.
      16. In one embodiment of the invention where the targeted metal based film contains oxygen, such as for example Ga₂O₃ the said reactant species include an oxygen source which is selected from, but not limited to, oxygen (O₂), oxygen radicals (for instance O. or OH.), for instance generated by a remote plasma, ozone (O₃), moisture (H₂O) and H₂O₂.
      17. In one embodiment of the invention where the targeted metal based film contains nitrogen such as InGaN, one or more reactant species containing nitrogen can be used. The said reactant species are selected from, but not limited to, nitrogen (N₂), ammonia, hydrazine and alkyl derivatives, N-containing radicals (for instance N., NH., NH₂.), NO, N₂O, NO₂, amines.
      18. In one embodiment of the invention, the said metal sources are simultaneously introduced and mixed into the reaction chamber.
      19. In another embodiment of the invention, the said metal sources are simultaneously introduced and mixed to reactant species into the reaction chamber.
      20. In one embodiment of the invention, the other metal sources are selected in the group of, but without limitation, GeCl₂, SbCl₃, TeCl₄, TDMAGe, TDMASb, DIPT...
      21. In one embodiment of the invention, the said precursor is used for atomic layer deposition of gallium containing films. The said gallium source, the possible said metal source and the reactant species are introduced sequentially in the reaction chamber (atomic layer deposition). The reactor pressure is selected in the range from 0.1 Pa to 13300 Pa. Preferably, the reactor pressure is comprised between 133 Pa and 1330 Pa. A purge gas is introduced between the metal source pulse and the reactant species pulse. The purge gas can be selected without limitation from the group consisting of N₂, Ar, He. The purge gas flow is in the range 100mL/min to 10L/min. The metal source, purge gas and reactant species pulse duration is comprised between 0.1 sand 100 s. Preferably, the pulse duration is comprised between 0.5 s and 10 s.
      22. In another embodiment of the invention, the deposition of the gallium containing thin film is performed by a combination of the previous elements (point 1 to 20).

### EXAMPLES

### A. Synthesis of [Me₂GaN(EtMe)]₂

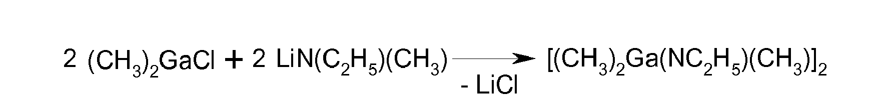

All operations are carried in an inert gas filled glove box. A mass of 324.5 mg (0.005 mmol) is added to a suspension of 0.827 g (0.005 mmol) of Me₂GaCl in 20 mL of ethanol. The mixture is stirred vigorously at room temperature for 24h then the mixture is filtered to separate the formed LiCl. Ethanol is removed under vacuum. The glassy product is sublimed. White crystals are obtained.

### B. Deposition of an gallium-nitride layer by ALD.

The gallium nitride is deposited at 550°C on a sapphire substrate using [Me₂Ga(NEtMe)]2 and NH₃ as reactive gas. The precursor is stored into canisters and sublimed at 70°C. N₂ is used as carrier gas. The precursor and reactive gas are simultaneously introduced into the reactor. A film of gallium nitride film is obtained.

### C. Deposition of an gallium-oxide layer by ALD.

The gallium nitride is deposited at 500°C on a sapphire substrate using [Me₂Ga(NEtMe)]₂ and ozone as reactive gas. The precursor is stored into canisters and sublimed at 70°C. N₂ is used as carrier gas. The precursor and reactive gas are simultaneously introduced into the reactor. A film of gallium oxide is obtained.

### D. Thermal characterization of [Me₂Ga(NEtMe)]₂

Figure 1 shows that the precursor is thermally stable at least until 230°C; and Figure 2 shows that it presents sufficient volatility for vapor phase distribution: 1100 Pa (8 Torr) at 100°C.

Consequently, [Me₂Ga(NEtMe)]₂ is thermally stable and has a good volatility at the same time in addition of the fact that it is not a pyrophoric compound.

### E. Pyrophoricity test of [Me₂Ga(NEtMe]₂

A sampling is performed in a glovebox under argon with a controlled level of oxygen and moisture (below 5 ppm). 250mg of powder are placed in a small glass crystallizer. The crystallizer is then placed in a leak proof screw cap jar during the transfer from the glovebox to a fume hood. The screw cap jar is opened under the fume hood and the crystallizer with the powder in placed directly in contact with air. No fumes are seen but there are some odours of amina (HNMe2). After 1 min, some drops of water are deposited directly on the product. Some bubbles are seen on the powder but without violent reaction.

We conclude that the product is not pyrophoric.

## Claims

1. Compounds of formula (I): [(Rₐ)(R_{b})Ga(NR_{c}R_{d})]₂, wherein:
- Ra and Rb are independently selected in the group consisting of H, C1-C6 linear or branched alkyl, aryl or alkylsilyl;
- Rc and Rd are independently selected in the group consisting of C1-C4 linear or branched alkyl, aryl or alkylsilyl.

2. Compounds according to Claim 1, wherein Ra and Rb are a methyl group.

3. Compounds according to Claim 1 or 2, wherein Rc and Rd which may be identical or different are independently chosen between methyl and ethyl.

4. The following compounds: [Me₂Ga(NEtMe)]₂, [Me₂Ga(NEt₂)]₂.

5. Method for forming a gallium containing thin film on a substrate comprising at least the steps of:
a) providing a vapor comprising at least one precursor compound of the formula (I) as defined in one of claims 1 to 4;
b) reacting the vapor comprising the at least one compound of formula (I) with the substrate, according to an atomic layer deposition process, to form a layer of an gallium-containing complex on at least one surface of said substrate.

6. Method according to Claim 5, wherein the at least one precursor compound of the formula (I) is [Me₂Ga(NEtMe)]₂ or [Me₂Ga(NEt₂)]₂.

7. Method according to Claim 5 or Claim 6 further comprising the step:
c) reaction of the complex formed obtained in step b) with a reagent selected from another metal source, reducing reactants and/or nitriding reactants and/or oxidizing reactants.

8. Method of manufacturing a semiconductor structure, comprising the steps of the method of one of claims 5 to 7, wherein the substrate is a semiconductor substrate.

9. Method of manufacturing a photovoltaic structure, comprising the steps of the method of one of claims 5 to 7, wherein the substrate is a photovoltaic substrate.

10. Use of at least one compound as defined in one of claims 1 to 4 for the manufacturing of phase change materials (PCM).
